(19) Europäisches Patentamt
European Patent Office
Office européen des brevets

(11) **EP 2 860 764 B1**

(12) **EUROPEAN PATENT SPECIFICATION**

(45) Date of publication and mention
of the grant of the patent:
**24.07.2019 Bulletin 2019/30**

(51) Int Cl.:
***H01L 31/049*** *(2014.01)*

(21) Application number: **13801218.2**

(22) Date of filing: **05.06.2013**

(86) International application number:
**PCT/JP2013/065543**

(87) International publication number:
**WO 2013/183658 (12.12.2013 Gazette 2013/50)**

(54) **SOLAR BATTERY REAR FACE PROTECTION SHEET**

RÜCKSEITIGE SCHUTZFOLIE EINER SOLARBATTERIE

FEUILLE DE PROTECTION POUR FACE ARRIÈRE DE BATTERIE SOLAIRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.06.2012 JP 2012130256**

(43) Date of publication of application:
**15.04.2015 Bulletin 2015/16**

(73) Proprietor: **Toyo Aluminium Kabushiki Kaisha Osaka-shi, Osaka 541-0056 (JP)**

(72) Inventors:
• **MAEDA, Daisuke**
  **Osaka-shi**
  **Osaka 541-0056 (JP)**
• **SARUWATARI, Masataka**
  **Osaka-shi**
  **Osaka 541-0056 (JP)**
• **FUJINO, Takaaki**
  **Osaka-shi**
  **Osaka 541-0056 (JP)**

(74) Representative: **Nieuwenhuys, William Francis Marks & Clerk LLP**
  **15 Fetter Lane**
  **London EC4A 1BW (GB)**

(56) References cited:
**WO-A1-2011/148737       JP-A- 2010 089 281**
**JP-A- 2011 009 392       JP-A- 2011 009 392**
**JP-A- 2012 019 138       JP-A- 2012 069 835**

**Description**

Technical Field

The present invention relates to a solar cell rear face protection sheet that is, in use, disposed on the rear face side of a solar cell.

Background Art

A solar cell typically has a solar cell rear face protection sheet laminated on its rear side, and a laminate composed of a solar cell and a protection sheet is generally referred to as a solar cell module.

When a solar cell module is disposed on a roof or on a rooftop, the solar cell rear face protection sheet of the module may be required to be black in view of appearance and design characteristics. Accordingly, for black solar cell rear face protection sheets, there have been proposed, for example, an embodiment using a black resin film comprising a black pigment such as carbon black, an embodiment applying a black coating as a base resin film (e.g., a polyethylene terephthalate film), and an embodiment incorporating a black pigment, such as carbon black, into an adhesive layer for bonding resin films together (see, for example, PTL 1 and 2).

PTL 3 discloses a backside protective film for a solar cell, which comprises a first resin layer and a second resin layer that is disposed on one surface of the first resin layer. The first resin layer has a thickness of 10-400 $\mu$m and contains a rubber-containing aromatic vinyl resin having a highest glass transition temperature of 90-120°C and an infrared light transmitting coloring agent. The second resin layer has a thickness of 10-400 $\mu$m and contains a saturated polyester resin and a white coloring agent.

However, conventional solar cell rear face protection sheets comprising carbon black as a black pigment have been criticized for their poor electrical insulation and reduced power generation efficiency due to absorption of sunlight in the near-infrared and infrared regions, which tends to increase the temperature of the solar cell. In particular, the power generation efficiency of crystalline silicon-based solar cells is said to decrease by about 0.4%/°C as the temperature increases.

Therefore, the development of a black solar cell rear face protection sheet that inhibits absorption of sunlight in the near-infrared and infrared regions is desired.

Citation List

PTL

PTL 1:
JP2009-249421A
PTL 2:
JP2008-053470A
PTL 3:
WO 2011/148737 A1

Summary of Invention

Technical Problem

An object of the present invention is to provide a black solar cell rear face protection sheet that inhibits absorption of sunlight in the near-infrared and infrared regions. Solution to Problem

The present inventors conducted extensive research to achieve the above object. As a result, the inventors found that when a solar cell rear face protection sheet is formed of a stack of two or more layers including a black layer, and has a light reflectivity within a specific range, the above object can be achieved. The present invention has been accomplished based on this finding.

The present invention provides the following solar cell rear face protection sheet.

1. A solar cell rear face protection sheet that is, in use, disposed on the rear face side of a solar cell, wherein: (1) the solar cell rear face protection sheet is composed of a stack of two or more layers; (2) the layer that is, in use, nearest the rear face of the solar cell among the layers constituting the stack comprises two or more types of organic pigments, has an average reflectivity of 10% or less in the wavelength range of 380 to 780 nm, is black, and comprises polyethylene having a density of 0.900 to 0.935 g/cm$^3$, wherein the two or more types of organic pigments comprise a combination of copper phthalocyanine pigment, quinacridone red pigment, and benzimidazolone yellow pigment; and (3) the solar cell rear face protection sheet has an average reflectivity of 30% or more in the wavelength range of 780 to 2,000 nm.

2. A solar cell module comprising a solar cell, and the solar cell rear face protection sheet according to Item 1 disposed on the rear face side of the solar cell.

Description of Embodiments

The solar cell rear face protection sheet according to the present invention, and the solar cell module according to the present invention comprising the solar cell rear face protection sheet disposed on the rear face side of a solar cell are described below in detail.

Solar cell rear face protection sheet

The solar cell rear face protection sheet according to the present invention has features in that, in use, the sheet is disposed on the rear face side of a solar cell, wherein:

(1) the solar cell rear face protection sheet is composed of a stack of two or more layers;
(2) the layer that is, in use, nearest the rear face of the solar cell (hereinafter sometimes referred to as "the first resin layer") among the layers constituting the stack comprises two or more types of organic pigments, has an average reflectivity of 10% or less in the wavelength range of 380 to 780 nm, and is black, and comprises polyethylene having a density of 0.900 to 0.935 g/cm$^3$, wherein the two or more types of organic pigments comprise a combination of copper phthalocyanine pigment, quinacridone red pigment, and benzimidazolone yellow pigment; and
(3) the solar cell rear face protection sheet has an average reflectivity of 30% or more in the wavelength range of 780 to 2,000 nm.

The solar cell rear face protection sheet of the present invention having the above features is black particularly because the first resin layer comprises two or more types of organic pigments, and has an average reflectivity of 10% or less in the wavelength range of 380 to 780 nm. Accordingly, when the solar cell rear face protection sheet of the solar cell module is viewed from the solar cell side, the sheet is black.

Furthermore, because the solar cell rear face protection sheet of the present invention has an average reflectivity of 30% or more in the wavelength range of 780 to 2,000 nm (near-infrared and infrared ranges), light in the near-infrared and infrared regions transmitted through the first resin layer is efficiently reflected by other layers, thus inhibiting the reduction of power generation efficiency due to temperature rise. More specifically, particularly because the average reflectivity in the wavelength range of 780 to 1,200 nm is 30% or more, an effect of enhancing power generation efficiency by effective use of light is obtained. Particularly because the average reflectivity in the wavelength range of 1,200 to 2,000 nm is 30% or more, an effect of inhibiting temperature rise of the solar cell module is obtained.

The layer structure of the solar cell rear face protection sheet of the present invention is not limited as long as the sheet is composed of a stack of two or more layers including a first resin layer, and both the first resin layer and the entire sheet have an average reflectivity that meets the aforementioned requirements. Examples of the layer structure include a two-layer structure as illustrated in Fig. 1 (the adhesive layer not being counted as a layer), a three-layer structure as illustrated in Fig. 2 (the adhesive layers not being counted as layers), and a four-layer structure as illustrated in Fig. 3 (the adhesive layers not being counted as layers).

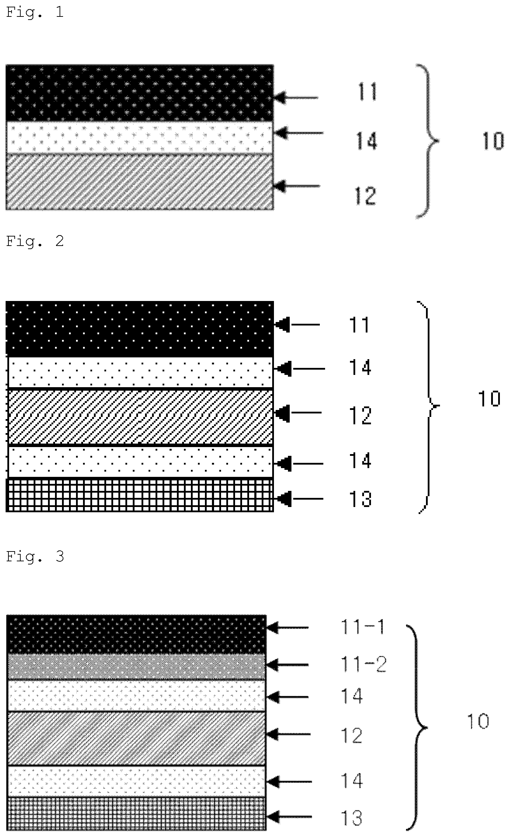

The layer structures are explained below with reference to Figs. 1, 2, and 3.

The solar cell rear face protection sheet 10 illustrated in Fig. 1 comprises: a first resin layer 11, which is, in use, nearest the rear face of the solar cell; and a second resin layer 12 bonded to the first layer via an adhesive layer 14. The solar cell rear face protection sheet 10 illustrated in Fig. 2 comprises: a first resin layer 11, which is, in use, nearest the rear face of the solar cell; a second resin layer 12; and a third resin layer 13, each of the layers being bonded together via an adhesive layer 14. The solar cell rear face protection sheet 10 illustrated in Fig. 3 comprises a first resin layer 11-1 and a fourth resin layer 11-2 laminated by multilayer extrusion, the first resin layer being, in use, nearest the rear face of the solar cell, and further comprises a second resin layer 12 and a third resin layer 13, each of the fourth resin layer 11-2, second resin layer 12, and a third resin layer 13 being bonded together via an adhesive layer 14. Although the first and fourth layers are different layers, these layers are simultaneously laminated by multilayer extrusion. Accordingly, as indicated by "11-1" and "11-2," these layers are explained together as a whole.

<<First resin layer>>

The resin component of the first resin layer is not particularly limited. For example, the following resins can be used to form a film or sheet: polyolefin resins such as polyethylene (PE) (e.g., high-density polyethylene, low-density polyethylene, and linear low-density polyethylene (LLDPE)), polypropylene (PP), polybutene; (meth)acrylic resins, polyvinyl chloride resins, polystyrene resins, polyvinylidene chloride resins, ethylene-vinyl acetate copolymer saponification products, polyvinyl alcohols, polycarbonate resins, fluororesins (e.g., polyvinylidene fluoride, polyvinyl fluoride, and ethylenetetrafluoroethylene), polyvinyl acetate resins, acetal resins, polyester resins (e.g., polyethylene terephthalate (PET), polybutylene terephthalate, and polyethylene naphthalate), polyamide resins, and polyphenylene ether resins. Such a film or sheet may comprise one or more types of resin components, and may be stretched uniaxially or biaxially.

A solar cell typically comprises a sealing member as the bottom layer. A widely used material for sealing members is an ethylene-vinyl acetate copolymer (EVA). The adhesion between the sealing member and the solar cell rear face protection sheet affects long-term reliability of a solar cell module. Accordingly, the type of resin component of the first resin layer is preferably selected from the viewpoint of adhesion in consideration of the material of the sealing member.

For example, when the material of the sealing member is EVA, polyethylene (PE) (e.g., high-density polyethylene, low-density polyethylene, or linear low-density polyethylene (LLDPE)) is preferable as the resin component. Among these, LLDPE is more preferable. In the present invention, LLDPE having a density of 0.900 to 0.935 g/cm$^3$ is preferably used as a resin component of the first resin layer so that the first resin layer has a density of about 0.910 to 0.990 g/cm$^3$.

In the present invention, the first resin layer is black because the layer comprises two or more types of organic pigments, and has an average reflectivity of 10% or less in the wavelength range of 380 to 780 nm. When the average reflectivity of the first resin layer in the wavelength range of 380 to 780 nm is more than 10%, the first resin layer is black but has a slight green tint. In contrast, when the average reflectivity of the first resin layer in the wavelength range of 380 to 780 nm is 10% or less, the first resin layer is deep black and has improved design characteristics as the solar cell rear face protection sheet.

Because black is created in this manner by incorporating (mixing) two or more types of organic pigments, absorption of sunlight in the near-infrared and infrared regions can be more effectively inhibited compared to the case of using a monochromatic black pigment (e.g., carbon black). Because the solar cell rear face protection sheet has an average reflectivity of 30% or more in the wavelength range of 780 to 2,000 nm, light in the near-infrared and infrared regions transmitted through the first resin layer are efficiently reflected by other layers, thus inhibiting reduction of power generation efficiency due to temperature rise. More specifically, particularly because the average reflectivity in the wavelength range of 780 to 2,000 nm is 30% or more, an effect of enhancing power generation efficiency by effective use of light is obtained. Particularly because the average reflectivity in the wavelength range of 1,200 to 2,000 nm is 30% or more, an effect of inhibiting temperature rise of the solar cell module is obtained.

In the present invention, the aforementioned reflectivity characteristics are obtained for the following reason. If the first resin layer contains only one type of black pigment such as carbon black, light in all the visible, near-infrared, and infrared wavelengths is absorbed, and very little light is allowed to pass through the first resin layer. In contrast, when the first resin layer is made black by incorporating (mixing) two or more types of organic pigments, visible wavelength light is absorbed, whereas near-infrared and infrared wavelength light is hardly absorbed and is transmitted through the first resin layer. Accordingly, the transmitted near infrared and infrared light is reflected by other layers and allowed to re-enter the solar cell module, thereby inhibiting temperature rise of the solar cell and enhancing power generation efficiency by effective use of light.

Examples of organic pigments that can be used in the present invention include azo pigments, phthalocyanine pigments, condensed polycyclic pigments, and other organic pigments.

Specific examples of azo pigments include soluble azo pigments, insoluble azo pigments, condensed azo pigments, and the like. Examples of phthalocyanine pigments include copper phthalocyanine pigments, metal-free phthalocyanine pigments, copper naphthalocyanine pigments, silicon naphthalocyanine pigments, and germanium naphthalocyanine pigments. Examples of condensed polycyclic pigments include anthraquinone-based pigments, threne-perinone-based pigments, pyrylene-based pigments, quinacridone-based pigments, dioxazine-based pigments, isoindolinone-based pigments, and quinophthalone-based pigments. Examples of other organic pigments include diketopyrrolopyrrole pigments, benzimidazolone pigments, triphenylmethane pigments, and metal complex pigments.

Specific examples of soluble azo pigments include acetoacetanilide-based pigments, pyrazolone-based pigments, β-naphthol-based pigments, β-oxynaphthoic acid-based pigments, and β-oxynaphthoic acid anilide-based pigments. Examples of insoluble azo pigments include (monoazo or disazo)acetoacetanilide-based pigments, (monoazo or disazo)pyrazolone-based pigments, β-naphthol-based pigments, and (monoazo or disazo)β-oxynaphthoic acid anilide-based pigments. Examples of condensed azo pigments include acetoacetanilide-based pigments and β-oxynaphthoic acid anilide-based pigments. Examples of copper phthalocyanine pigments include copper phthalocyanine (blue), copper halide phthalocyanine (blue, green) pigments, and sulfonated copper phthalocyanine lake pigments. Examples of anthraquinone-based pigments include aminoanthraquinone pigments, anthrapyrimidine (yellow), flavanthrone pigments, anthanthrone pigments, indanthrone pigments, pyranthrone pigments, and violanthrone pigments. Examples of threne-perinone-based pigments include perinone pigments. Examples of perylene-based pigments include perylene pigments and perylene maroon pigments. Examples of quinacridone pigments include quinacridone red pigments, quinacridone maroon pigments, and quinacridone gold pigments. Examples of dioxazine-based pigments include dioxazine pigments and dioxazine violet pigments. Examples of isoindolinone-based pigments include isoindolinone pigments, isoindolinone yellow pigments, isoindolinone orange pigments, and indanthrone pigments. Examples of quinophthalone-based pigments include quinophthalone pigments. Examples of diketopyrrolopyrrole-based pigments include diketopyrrolopyrrole pigments. Examples of benzimidazolone-based pigments include benzimidazolone yellow pigments and benzimidazolone yellow pigments. Examples of triphenylmethane-based pigments include triphenylmethane pigments. Examples of metal complex pigments include azomethine copper complex pigments.

In the present invention, the combination of such organic pigments is not particularly limited as long as black is created by mixing two or more types of organic pigments. In the present invention a combination of copper phthalocyanine pigment, quinacridone red pigment, and benzimidazolone yellow pigment isused. The term "black" in the present invention means that the average reflectivity in the wavelength range of 380 to 780 nm is 15% or less (preferably 10% or less). The term "average reflectivity" as used herein means the average value determined by measuring the reflectivity of the first resin layer in the wavelength range of 380 to 780 nm at intervals of 2 nm using a spectrophotometer (product name "V-570," produced by Jasco Corporation). When the average reflectivity is 15% or less, the black design characteristic requirement can be satisfied. The average reflectivity in other wavelength ranges was also measured in the same manner.

The method for forming the first resin layer may be, for example, a film formation method, such as T-die extrusion molding or inflation molding. Alternatively, the first resin layer may be formed by simultaneous multilayer extrusion of the first resin layer with the second, third, and fourth resin layers described below. The method of adding two or more types of organic pigments is preferably a method comprising first preparing a master batch comprising one or more types of organic pigments, and then mixing a predetermined amount of the master batch with a matrix resin for the first resin layer.

The thickness of the first resin layer is not limited, and can be suitably set according to the desired properties of the final product. The thickness is preferably 10 to 200 $\mu$m, and more preferably 30 to 150 $\mu$m.

<<Second resin layer>>

The second resin layer preferably has excellent weatherability and excellent electrical insulation. As the resin component of the second resin layer, for example, the following resins can be used to form a film or sheet: polyolefin resins such as polyethylene (PE) (e.g., high-density polyethylene, low-density polyethylene, and linear low-density polyethylene (LLDPE)), polypropylene (PP), and polybutene, (meth)acrylic resins, polyvinyl chloride resins, polystyrene resins, polyvinylidene chloride resins, ethylene-vinyl acetate copolymer saponification products, polyvinyl alcohols, polycarbonate resins, fluororesins (e.g., polyvinylidene fluoride, polyvinyl fluoride, and ethylenetetrafluoroethylene), polyvinyl acetate resins, acetal resins, polyester resins (e.g., polyethylene terephthalate (PET), polybutylene terephthalate, and polyethylene naphthalate), polyamide resins, and polyphenylene ether resins. Such a film or sheet may comprise one or more types of resin components, and may be stretched uniaxially or biaxially.

When the second resin layer is composed of a single layer film, the thickness is preferably 50 to 300 $\mu$m, and more preferably 75 to 250 $\mu$m.

When the second resin layer is formed of a laminate of films, a laminate composed of a film having excellent weatherability and a film having excellent electrical insulation is preferable. In this case, the films are arranged so that the film having excellent electrical insulation is disposed on the first resin layer side. The film having excellent weatherability is preferably a fluorine-based film having a thickness of 10 to 150 $\mu$m (at least one member selected from polyvinylidene fluoride, polyvinyl fluoride, and ethylene tetrafluoroethylene). The film having excellent electrical insulation is particularly preferably a PET film having a thickness of 50 to 250 $\mu$m.

The second resin layer may contain a white pigment, such as titanium dioxide or barium sulfate, in order to absorb or reflect UV light, and reflect the near-infrared and infrared light transmitted through the first resin layer. The amount of white pigment to be added can be suitably set according to the type of white pigment and the desired reflectivity characteristics. Addition of the white pigment allows near-infrared and infrared light to be reflected and re-enter the solar cell, thus inhibiting temperature rise and resulting in enhanced power generation efficiency. Because the first resin layer is black in the present invention, the addition of a white pigment to the second resin layer does not affect black design characteristics as is viewed from the solar cell side.

Further, known additives other than color pigments, such as UV absorbers, water absorbents (desiccants), and antioxidants may be added not only to the second resin layer, but also to the first resin layer and/or the third resin layer described below.

According to the present invention, the solar cell rear face protection sheet must have a feature such that the average reflectivity in the wavelength range of 780 to 2,000 nm is 30% or more, and preferably 35% or more. Particularly because the average reflectivity in the wavelength range of 780 to 1,200 nm is 30% or more, an effect of enhancing power generation efficiency based on effective use of light can be obtained. Particularly because the average reflectivity in the wavelength range of 1,200 to 2,000 nm is 30% or more, an effect of inhibiting temperature rise of the solar cell module can be obtained. In the present invention, a white pigment is preferably added to the second resin layer to meet the above requirement of the average reflectivity. However, if necessary, it is also possible to add a white pigment not to the second resin layer but to the third resin layer described below.

«Third resin layer»

When a third resin layer is provided, the third resin layer preferably has a particularly high weatherability. As the resin component of the third resin layer, for example, the following resins can be used to form a film or sheet: polyesters such as polyethylene naphthalate (PEN) and polyethylene terephthalate (PET); fluororesins such as polyvinylidene fluoride (PVDF), polyvinyl fluoride (PVF), and ethylene tetrafluoroethylene (ETFE); polyolefins such as polyethylene and polypropylene; polystyrene; polyvinyl chloride; polyacrylonitrile; polyimide; and engineering plastics. Such a film or sheet may comprise one or more types of resin components, and may be stretched uniaxially or biaxially.

Among these resin components, at least one of PET, fluororesins, and engineering plastics is particularly preferable.

As the PET, hydrolysis-resistant PET is preferable in consideration of durability of the solar cell rear face protection sheet in outdoor use.

Specific examples of the engineering plastics include polyacetal (POM), polyamide (PA), polycarbonate (PC), modified polyphenylene ether (m-PPE), polybutylene terephthalate (PBT), GF-reinforced polyethylene terephthalate (GF-PET), ultra-high-molecular-weight polyethylene (UHPE), syndiotactic polystyrene (SPS), amorphous polyarylate (PAR), polysulfone (PSF), polyether sulfone (PES), polyphenylene sulfide (PPS), polyether ether ketone (PEEK), polyimide (PI), polyether imide (PEI), polyphenylene ether (PPE), and liquid crystal polymers (LCP).

In the present invention, when the second resin layer does not contain a white pigment such as titanium dioxide and barium sulfate, such a white pigment is added to the third resin layer. This allows near-infrared and infrared light transmitted through the first and second resin layers to be reflected and re-enter the solar cell, thus inhibiting temperature rise and further enhancing power generation efficiency.

The third resin layer may be a monolayer or multilayer. The third resin layer preferably has a thickness of 5 to 50 $\mu$m, and more preferably 10 to 25 $\mu$m.

<<Fourth resin layer>>

In the present invention, addition of a white pigment, such as titanium dioxide or barium sulfate, to the second resin layer and/or the third resin layer allows for reflection of near-infrared and infrared light transmitted through the first resin layers. However, if near-infrared and infrared light is reflected at a position closer to the solar cell, inhibition of temperature rise of the solar cell and power generation efficiency can be further enhanced.

More specifically, a fourth resin layer comprising a white pigment can be formed between the first and second resin layers to enhance temperature rise inhibition and power generation efficiency. This is particularly effective in embodiments in which a white pigment is added only to the third resin layer, and is not added to the second resin layer.

The fourth resin layer can be formed by a film formation method, such as T-die extrusion molding and inflation molding. Forming the fourth resin layer by subjecting the first and fourth resin layers to multilayer extrusion molding using a T-die is particularly preferable. To facilitate the film formation by multilayer extrusion, the resin of the fourth resin layer is preferably the same as the resin of the first resin layer. The resin as explained above in the section of the first resin layer can also be used in the fourth resin layer.

Because the first resin layer is black in the present invention, addition of a white pigment to the fourth resin layer does not affect black design characteristics as is viewed from the solar cell side. Examples of the white pigment include titanium dioxide and barium sulfate. The amount of white pigment to be added can be suitably set according to the type of white pigment and the desired reflectivity characteristics. The fourth resin layer may contain known additives, such as water absorbents (dessicants), oxygen absorbers, and antioxidants.

The thickness of the first resin layer is not limited, and can be suitably set according to the desired properties of the final product. The thickness is preferably 10 to 150 $\mu$m, and more preferably 30 to 90 $\mu$m. When the fourth resin layer is formed, the thickness of the first resin layer is preferably set to 30 to 90 $\mu$m.

<<Adhesive layer>>

An adhesive layer may be provided between each of the first, second, third, and fourth resin layers. For example, when the first, second, third, and fourth resin layers are laminated by extrusion coating, dry lamination, heat lamination, and like methods, forming an adhesive layer between the layers is preferable.

Examples of the adhesive layer include two-component curable urethane adhesives, polyether urethane adhesives, polyester adhesives, polyester polyol adhesives, and polyester polyurethane polyol adhesives. In particular, a dry lamination method using a urethane adhesive comprising at least one of aromatic isocyanates and aliphatic isocyanates can be preferably used.

The thickness of the adhesive layer is preferably 3 to 15 $\mu$m, and more preferably 5 to 10 $\mu$m.

Solar cell module

The solar cell rear face protection sheet of the present invention is disposed on the rear face side of a solar cell to form a solar cell module. Although the structure of the solar cell is not limited, the solar cell is typically configured in such a manner that toughened glass for solar cells, EVA, a crystalline Si cell, and EVA (sealing member) are layered in this order from the front face side.

Advantageous Effects of Invention

The solar cell rear face protection sheet of the present invention is black particularly because the sheet comprises two or more types of organic pigments in the first resin layer, and has an average reflectivity of 10% or less in the wavelength range of 380 to 780 nm. Accordingly, a solar cell module comprising the protection sheet is black when the solar cell rear face protection sheet is viewed from the solar cell side. Because the solar cell rear face protection sheet of the present invention has an average reflectivity of 30% or more in the wavelength range of 780 to 2,000 nm (near-infrared and infrared regions), light in the near-infrared and infrared regions transmitted through the first resin layer is efficiently reflected by other layers, thus inhibiting reduction of power generation efficiency due to temperature rise. More specifically, particularly because the average reflectivity in the wavelength range of 780 to 1,200 nm is 30% or more, an effect of enhancing power generation efficiency by effective use of light is obtained. Particularly because the average reflectivity in the wavelength range of 1,200 to 2,000 nm is 30% or more, an effect of inhibiting temperature rise of the solar cell module is obtained. Brief Description of Drawings

Fig. 1 is a diagram illustrating the layer structure of the solar cell rear face protection sheet according to one embodiment of the present invention.
Fig. 2 is a diagram illustrating the layer structure of the solar cell rear face protection sheet according to another embodiment of the present invention.
Fig. 3 is a diagram illustrating the layer structure of the solar cell rear face protection sheet according to yet another embodiment of the present invention.

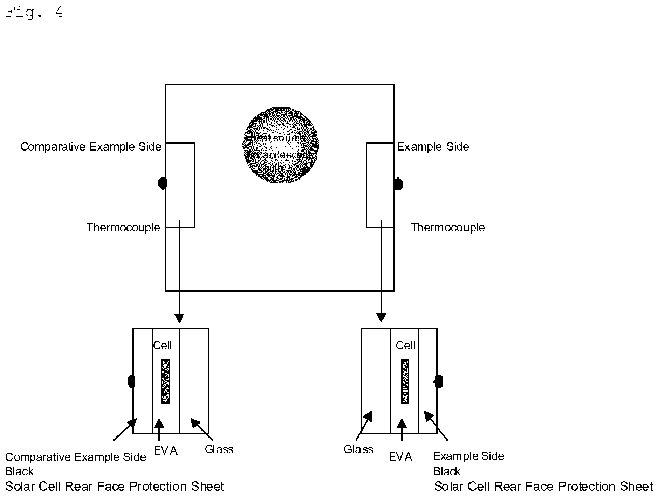

Fig. 4 is a schematic diagram of a temperature-rise comparison device (wooden box) for investigating comparisons between the solar cell modules in temperature rise.

Examples

The present invention is described in detail below with reference to Examples and Comparative Examples. However, the present invention is not limited to the Examples.

Example 1

50 parts by mass of copper phthalocyanine was kneaded into 100 parts by mass of LLDPE having a density of 0.913 g/cm$^3$ (Evolue; produced by Mitsui Chemicals, Inc.) to prepare a color master batch. Color master batches comprising quinacridone red and benzimidazolone yellow were also prepared in a similar manner.

Five parts by mass of each of the color master batches (copper phthalocyanine, quinacridone red, and benzimidazolone yellow) was mixed with 100 parts by mass of LLDPE having a density of 0.922 g/cm$^3$ (Evolue; produced by Mitsui Chemicals, Inc.). Each of the resulting mixtures was extruded using a T-die extruder to obtain a black LLDPE film with a thickness of 50 $\mu$m as a first resin layer.

A white PET film with a thickness of 188 $\mu$m (produced by Teijin Ltd.) was prepared as a second resin layer. A dry lamination adhesive was used to bond the second resin layer to the first resin layer by a dry lamination method. A black solar cell rear face protection sheet was thus produced. The white PET film comprised titanium dioxide as a white pigment.

As the dry lamination adhesive, a polyurethane adhesive produced by mixing 100 parts by mass of "Takelac A315" (trade name, produced by Mitsui Chemicals, Inc.) and 10 parts by mass of "Takenate A50" was applied to a coating thickness of 5 g/m$^2$, on a solids basis.

Example 2

A transparent PET film (produced by Teijin Ltd.) having a thickness of 250 $\mu$m was prepared as a second resin layer. A white polyvinyl fluoride (PVF) film (Tedlar, produced by DuPont) having a thickness of 38 $\mu$m was prepared as a third resin layer. The white PVF film comprised titanium dioxide as a white pigment.

A dry lamination adhesive was applied to one side of the second resin layer to bond the first resin layer (a black LLDPE film having a thickness of 50 $\mu$m) of Example 1 thereto. The dry lamination adhesive was also applied to the opposite side of the second resin layer to bond a PVF film of the third resin layer thereto. A black solar cell rear face protection sheet was thus produced.

The dry lamination adhesive was the same as used in Example 1.

Example 3

50 parts by mass of copper phthalocyanine was kneaded into 100 parts by mass of LLDPE having a density of 0.913 g/cm$^3$ (Evolue; produced by Mitsui Chemicals, Inc.) to prepare a color master batch. Color master batches comprising quinacridone red and benzimidazolone yellow were also prepared in a similar manner.

Similarly, 50 parts by mass of titanium dioxide was kneaded into 100 parts by mass of LLDPE having a density of 0.913 g/cm$^3$ (Evolue; produced by Mitsui Chemicals, Inc.) to prepare a white master batch.

Five parts by mass of each of the color master batches (copper phthalocyanine, quinacridone red, and benzimidazolone yellow) was mixed with 100 parts by mass of LLDPE having a density of 0.922 g/cm$^3$ (Evolue; produced by Mitsui Chemicals, Inc.) to prepare materials for the first resin layer. Twenty parts by mass of a white master batch was mixed with 100 parts by mass of LLDPE having a density of 0.922 g/cm$^3$ (Evolue; produced by Mitsui Chemicals, Inc.) to prepare a material for the fourth resin layer. Each of the materials for the first layer and the material for fourth layer were co-extruded using a T-die extruder to form a multilayer film, thus obtaining a laminate of each first resin layer (black, 50 $\mu$m) and the fourth resin layer (white, 50 $\mu$m).

A transparent PET film (produced by Teijin Ltd.) having a thickness of 250 $\mu$m was prepared as a second resin layer, which was bonded to the fourth resin layer. Further, a white polyvinyl fluoride (PVF) film (Tedlar, produced by DuPont) having a thickness of 38 $\mu$m was prepared as a third resin layer, which was bonded to the opposite side of the second resin layer. The white PVF film comprised titanium dioxide as a white pigment. A black solar cell rear face protection sheet was thus produced.

The dry lamination adhesive used was the same as in Example 1.

Example 4

50 parts by mass of copper phthalocyanine was kneaded into 100 parts by mass of LLDPE having a density of 0.913 g/cm$^3$ (Evolue; produced by Mitsui Chemicals, Inc.) to prepare a color master batch. Color master batches comprising quinacridone red and benzimidazolone yellow were also prepared in a similar manner.

Similarly, 50 parts by mass of titanium dioxide was kneaded into 100 parts by mass of LLDPE having a density of 0.913 g/cm$^3$ (Evolue; produced by Mitsui Chemicals, Inc.) to prepare a white master batch.

Five parts by mass of each of the color master batches (copper phthalocyanine, quinacridone red, and benzimidazolone yellow) was mixed with 100 parts by mass of LLDPE having a density of 0.922 g/cm$^3$ (Evolue; produced by Mitsui Chemicals, Inc.) (to prepare materials for the first resin layer). Twenty parts by mass of a white master batch was mixed with 100 parts by mass of LLDPE having a density of 0.922 g/cm$^3$ (Evolue; produced by Mitsui Chemicals, Inc.) (to prepare a material for the fourth resin layer) . Each of the materials for the first layer and the material for the fourth layer were co-extruded using a T-die extruder to form a multilayer film, thus obtaining a laminate of each first resin layer (black, 50 $\mu$m) and the fourth resin layer (white, 50 $\mu$m).

A transparent PET film (produced by Teijin Ltd.) having a thickness of 125 $\mu$m was prepared as a second resin layer, which was bonded to the fourth resin layer. A white weather-resistant PET film (Shine Beam, produced by Toyobo Co., Ltd.) having a thickness of 50 $\mu$m was prepared as a third resin layer, which was bonded to the opposite side of the second resin layer. The white weather-resistant PET film of the third resin layer comprised titanium dioxide as a white pigment. A black solar cell rear face protection sheet was thus produced.

The dry lamination adhesive used was the same as in Example 1.

Comparative Example 1

A transparent PE film (produced by Tohcello Inc.) having a thickness of 50 μm was prepared as a first resin layer. A transparent PET film (produced by Teijin Ltd.) having a thickness of 250 μm was prepared as a second resin layer. A black ethylene tetrafluoroethylene (ETFE) film (produced by Asahi Kasei Corporation) having a thickness of 25 μm was prepared as a third resin layer.

Each of the layers was bonded together using a dry lamination adhesive to produce a black solar cell rear face protection sheet.

The dry lamination adhesive was the same as used in Example 1.

Comparative Example 2

A black solar cell rear face protection sheet was produced in the same manner as in Example 2, except that a black pigment (only carbon black) was used as the pigment of the first resin layer.

<Test Examples>

The average reflectivity of the black solar cell rear face protection sheets obtained in the Examples and Comparative Examples was determined. Solar cell modules were produced using the black solar cell rear face protection sheets to investigate power output characteristics and temperature-rise comparisons.

<Average reflectivity>

The average reflectivity of each of the solar cell rear face protection sheets in the wavelength ranges of 380 to 780 nm, 780 to 1,200 nm, 1,200 to 2,000 nm, and 780 to 2,000 nm was measured using a spectrophotometer (product name "V-570," produced by Jasco Corporation). The average reflectivity in the wavelength range of 380 to 780 nm refers to the average reflectivity of the first resin layer. The average reflectivity in the wavelength range of 780 to 2,000 nm refers to the average reflectivity of the entire solar cell rear face protection sheet.

Table 1 below shows the measurement results.

<Power output characteristics>

A solar cell was produced by using a vacuum laminator (LM-140X200S, produced by NPC Corporation) to laminate a toughened glass for solar cells, EVA, a crystalline Si cell, and EVA (sealing member) in this order. The rear face of the solar cell was EVA as the sealing member. The power output characteristics of the solar cell were measured in this state using a solar simulator (PXSS4K-1P, produced by Iwasaki Electric Co., Ltd.), and the obtained value was defined as an initial value (before bonding of BS).

Subsequently, solar cell modules were produced by bonding each of the solar cell rear face protection sheets to the rear face side of each solar cell using a vacuum laminator. The power output characteristics were determined again using the solar simulator to obtain measurement values (after bonding of BS). The term "BS" (back sheet) as used herein refers to a solar cell rear face protection sheet.

The change (%) in power output (Eff change rate) of each solar cell module before and after bonding of BS was calculated.

```
Change (%) = (Value after bonding of BS/Initial value) x 100
```

Table 1 shows the measurement results.

The results clearly show that the black solar cell rear face protection sheet obtained in the Examples contributes to power output enhancement, whereas the black solar cell rear face protection sheet obtained in the Comparative Examples does not contribute to power output enhancement at all.

EP 2 860 764 B1

Table 1

| | Structure of the solar cell rear face protection sheet | Average reflectivity (%) | | | | | Power output of the solar cell module |
|---|---|---|---|---|---|---|---|
| | | First resin layer alone | Entire solar cell rear face protection sheet | | | | |
| | "/" indicates the interface between each layer. | 380 to 780 nm | 380 to 780 nm | 780 to 1,200 nm | 1200 to 2000nm | 780 to 2,000 nm | Eff change rate from the initial value (%) |
| Example 1 | Mixed color black LLDPE: 50 μm/adhesive layer/white PET: 188 μm | 5.9 | 6.8 | 71.6 | 54.9 | 60.6 | 5.6 |
| Example 2 | Mixed color black LLDPE: 50 μm/adhesive layer/transparent PET: 250 μm/adhesive layer/ white PVF: 38 μm | 5.9 | 6.7 | 54.5 | 39.4 | 44.6 | 4.4 |
| Example 3 | Mixed color black LLDPE: 50 μm/white LLDPE: 50 μm/ adhesive layer/transparent PET: 250 μm/adhesive layer/ white PVF: 38 μm | 5.9 | 7.8 | 72.4 | 54.0 | 60.3 | 6.2 |
| Example 4 | Mixed color black LLDPE: 50 μm/white LLDPE: 50 μm/ adhesive layer/transparent PET: 125 μm/adhesive layer/ white PET: 50 μm | 5.9 | 7.7 | 69.4 | 49.3 | 56.2 | 5.8 |
| Comparative Example 1 | Transparent LLDPE: 50 μm/ adhesive layer/transparent PET: 250 μm/adhesive layer/ black ETFE: 25 μm | - (transparent) | 5.8 | 5.6 | 5.3 | 5.4 | -1.1 |
| Comparative Example 2 | Monochromatic black (carbon black) LLDPE: 50 μm/adhesive layer/transparent PET: 250 μm/ adhesive layer/white PET: 38 μm | 4.5 | 4.7 | 4.6 | 4.4 | 4.4 | -2.0 |

<Comparison of temperature rise>

The solar cell modules obtained in Examples 1 to 4 and those obtained in Comparative Example 1 and 2 were compared in temperature rise. More specifically, a black solar cell rear face protection sheet as an example and a black solar cell rear face protection sheet as a comparative example were disposed at predetermined positions of the temperature-rise comparison device (wooden box) shown in Fig. 3. Black solar cell rear face protection sheets of an Example and a Comparative Example were disposed at the same distance from a heat source (incandescent bulb). A thermocouple was attached to each black solar cell rear face protection sheet side. A heat source (incandescent bulb) was turned on to compare temperature rise values in time series and compare the maximum temperature differences. Table 2 shows the results.

The measurements of Comparative Example 1 and 2 were repeatedly performed when measurement of each of Examples 1 to 4 was performed. Table 2 thus shows the measurement results of Examples 1 to 4 versus the measurement results of Comparative Examples 1 to 2.

10

Table 2

| | Example 1 | Comparative Example 1 | Comparative Example 2 | Example 2 | Comparative Example 1 | Comparative Example 2 | Example 3 | Comparative Example 1 | Comparative Example 2 | Example 4 | Comparative Example 1 | Comparative Example 2 |
|---|---|---|---|---|---|---|---|---|---|---|---|---|
| Maximum temperature (°C) | 80.9 | 92.6 | 88.8 | 83.0 | 92.6 | 88.8 | 80.4 | 92.6 | 88.8 | 80.6 | 92.6 | 88.8 |
| Temperature difference (°C) | - | 11.7 | 7.9 | - | 9.6 | 5.8 | - | 12.2 | 8.4 | - | 12.0 | 8.2 |

As is clear from the results shown in Table 2, the solar cell modules of Examples 1 to 4 were significantly inhibited from temperature rise compared to the solar cell modules of Comparative Examples 1 and 2.

Description of Reference Symbols

10. Solar Cell Rear Face Protection Sheet
11. First Resin Layer
11-1. First Resin Layer
11-2. Fourth Resin Layer
12. Second Resin Layer
13. Third Resin Layer
14. Adhesive Layer

Claims

1.   A solar cell rear face protection sheet (10) that is, in use, disposed on the rear face side of a solar cell, wherein:

(1) the solar cell rear face protection sheet is composed of a stack of two or more layers;
(2) the layer (11) that is, in use, nearest the rear face of the solar cell among the layers constituting the stack comprises two or more types of organic pigments, has an average reflectivity of 10% or less in the wavelength range of 380 to 780 nm, is black, and comprises polyethylene having a density of 0.900 to 0.935 g/cm$^3$, wherein the two or more types of organic pigments comprise a combination of copper phthalocyanine pigment, quinacridone red pigment, and benzimidazolone yellow pigment; and
(3) the solar cell rear face protection sheet (10) has an average reflectivity of 30% or more in the wavelength range of 780 to 2,000 nm.

2.   A solar cell module comprising a solar cell, and the solar cell rear face protection sheet according to claim 1 disposed on the rear face side of the solar cell.

Patentansprüche

1.   Schutzfolie (10) für die Rückseite einer Solarzelle, die, bei Gebrauch, an der Rückseitenfläche einer Solarzelle angeordnet ist, wobei:

(1) die Schutzfolie für die Rückseite einer Solarzelle aus einer Stapelung von zwei oder mehr Lagen besteht;
(2) die Lage (11), die, bei Gebrauch, der Rückseite der Solarzelle unter den Lagen, die die Stapelung bilden, am nächsten ist, zwei oder mehr Typen von organischen Pigmenten umfasst, ein durchschnittliches Reflexionsvermögen von 10% oder weniger im Wellenlängenbereich von 380 bis 780 nm aufweist, schwarz ist, und Polyethylen mit einer Dichte von 0,900 bis 0,935 g/cm$^3$ umfasst, wobei die zwei oder mehr Typen von organischen Pigmenten eine Kombination von Kupfer-Phthalocyanin-Pigment, Chinacridon-rot-Pigment, und Benzimidazolon-gelb-Pigment umfassen; und
(3) die Schutzfolie (10) für die Rückseite einer Solarzelle ein durchschnittliches Reflexionsvermögen von 30% oder mehr im Wellenlängenbereich von 780 bis 2000 nm aufweist.

2.   Solarzellenmodul, umfassend eine Solarzelle, und die Schutzfolie für die Rückseite einer Solarzelle nach Anspruch 1, die an der Rückseitenfläche der Solarzelle angeordnet ist.

Revendications

1.   Feuille de protection (10) de face arrière de cellule solaire qui, en cours d'utilisation, est disposée sur la face arrière d'une cellule solaire, dans laquelle:

(1) la feuille de protection de face arrière de cellule solaire est composée d'un empilement de deux couches ou plus;

(2) la couche (11) qui, en utilisation, est la plus proche de la face arrière de la cellule solaire parmi les couches constituant l'empilement, comprend deux types de pigments organiques ou plus, a une réflectivité moyenne de 10% ou moins dans la plage de longueurs d'onde de 380 à 780 nm, est noire et comprend du polyéthylène ayant une densité de 0,900 à 0,935 g/cm3, dans lequel les deux types ou plus de pigments organiques comprennent une combinaison de pigment de phtalocyanine de cuivre, de pigment rouge de quinacridone et de pigment jaune de benzimidazolone; et

(3) la feuille de protection (10) de face arrière de cellule solaire a une réflectivité moyenne de 30% ou plus dans la plage de longueurs d'onde de 780 à 2 000 nm.

2. Module de cellule solaire comprenant une cellule solaire et la feuille de protection de face arrière de cellule solaire selon la revendication 1, disposée sur la face arrière de la cellule solaire.

Fig. 1

Fig. 2

Fig. 3

Fig. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009249421 A
- JP 2008053470 A
- WO 2011148737 A1